# EUROPEAN PATENT APPLICATION

(11) **EP 1 001 463 A2**
(43) Date of publication of application: **17.05.2000**
(21) Application number: 99308278.3
(22) Date of filing: 20.10.1999
(51) Int. Cl.: H01L 23/532

(54) **Aluminum interconnects for integrated circuits comprising titanium under and overlayers**

(30) Priority: 10.11.1998 US 189428
(71) Applicant: International Business Machines Corporation, Armonk, NY 10504 (US)
(72) Inventor: Cichy, Holmer U., Winchester, Hampshire S021 2JN (GB); Clavenger, Lawrence A., Winchester, Hampshire S021 2JN (GB); Filippi, Ronald G., Winchester, Hampshire S021 2JN (GB); Iggulden, Roy C., Winchester, Hampshire S021 2JN (GB); Restaino, Darryl D., Winchester, Hampshire S021 2JN (GB); Rodbell, Kenneth P., Winchester, Hampshire S021 2JN (GB); Weber, Stefan J., Winchester, Hampshire S021 2JN (GB); Weigand, Peter,, Winchester, Hampshire S021 2JN (GB)
(74) Representative: Boyce, Conor

(57) **Abstract**

An interconnect for an integrated circuit includes an underlayer (14) comprising titanium having reduced contamination for improved electromigration and for supporting another layer. An intermediate layer (18) comprising aluminum is deposited over the underlayer. An overlayer (20) comprising titanium having increased contamination relative to the underlayer to provide a reduced sheet resistance is applied over the intermediate layer. The resulting interconnect has improved reliability and functionality. A method is also provided.

## Description

The present invention relates generally to semiconductor devices and, more particularly, to interconnects for semiconductor integrated circuits having improved reliability performance and functionality. The invention also relates to a method of forming such interconnects.

Integrated circuits (ICs) typically incorporate and rely on aluminum (Al) based interconnections to carry current to and from active devices (i.e., Bipolar Transistors and Metal Oxide Semiconductor Field Effect Transistors (MOSFETS)). Interconnections of copper (Cu) and gold (Au) have also been used and continue to be used for a limited number of applications. The reliability of these interconnections is generally limited by a phenomenon known as electromigration.

Electromigration is the motion of metal atoms in a conductor due to the passage of current. It is basically a diffusion phenomenon in which metal ions and vacancies diffuse in opposite directions with the applied electric field appearing to act as the driving force.

Aluminum-based thin-film metallizations, which are widely used to form conductor patterns and silicate integrated circuits, are especially susceptible to failure caused by electromigration. Electromigration can lead to failure in these devices primarily by one of two failure mechanisms. In both mechanisms, diffusion of the interconnect metal occurs along grain boundaries to cause a net amount of aluminum to migrate in the direction of the electron flow.

In the first failure mechanism, aluminum diffuses away from a region in the interconnect faster than the availability of additional atoms can take its place. This diffusion forms vacancies. The diffusion of aluminum typically occurs from certain regions, often points where three grains touch, to create vacancies which coalesce at points of flux divergence. As a result, voids are left behind at the negative end of the interconnection. with continued aluminum mass transport, the void grows until a failure occurs in the interconnection. This is known as a void-open failure. Although a resistance increase is usually observed in multi-layered metallizations before catastrophic failure occurs, single-layered metallizations may show little or no resistance increase before failing catastrophically.

The second mechanism, by which electromigration failure occurs, is caused by the electromigration of metal atoms into a region faster than the atoms escape the region. This discrepancy creates a local pile-up of metal atoms downstream of the electron flow to form hillocks, or small hills, at the positive end of the interconnection. In confined metal interconnects, such as those deposited on an oxidized silicon substrate and covered by a dielectric passivation layer, the accumulation of metal atoms due to continued mass transport exerts pressure on surrounding insulator layers which are contiguous to the interconnect. As the pressure increases, cracks form in the insulator into which aluminum can extrude. Short circuit failures, known as extrusion-short failures, occur when the extruded material extends and contacts adjacent interconnection lines to cause electrical short circuits. As microelectronics circuits are made more dense in order to improve performance, the electric fields (and resulting current densities) in the aluminum interconnects increase. Hence, as circuit densities increase, the rate of electromigration also increases.

Conventional efforts to reduce the probability of electromigration failures for a given time, temperature, and current typically include fabricating conducting interconnects which attempt to reduce flux divergence by eliminating structural non-uniformities. U.S. Patents No. 4,438,450 issued to Sheng et al.; No. 5,101,261 issued to Maeda; and No. 5,382,831 issued to Atakov et al., all attempt to reduce the diffusion flux in single-layer metallization interconnect structures by creating a plurality of narrow interconnect conductors for an integrated circuit in place of a single, wider conductor. In this manner, the metal grains can be oriented to act as blocking grains to prevent the formation of a continuous path of grain boundaries along the length of the patterned conductor.

The problem of electromigration increases for multi-level interconnect structures because narrower line widths lead to higher current densities. U.S. Patents No. 4,166,279 issued to Gangulee et al. and No. 5,071,714 issued to Rodbell et al. illustrate an approach in which redundant underlayers, overlayers, or both are incorporated on the interconnect to provide an alternate connective electrical path should a void-open occur in the metal interconnect.

U.S. Patent No. 5,943,601, describes a method of depositing onto a substrate a first layer of titanium and then a layer of aluminum, aluminum alloy, or both aluminum and aluminum alloy. The resulting metallization structure exhibits enhanced electromigration characteristics and is both highly textured and free of hillocks. Moreover, the metallization structure produced by the method exhibits relatively low resistivity and is relatively easy to fabricate.

Nevertheless, there still remains room for improvement of the electromigration characteristics. Accordingly, an object of the present invention is to provide a structure that exhibits enhanced electromigration performance while maintaining other favourable performance characteristics.

The present invention provides an interconnect structure for an integrated circuit having improved reliability and functionality. The interconnect structure includes a titanium underlayer and a titanium overlayer wherein the titanium layers differ from one another in their cleanliness. The titanium underlayer has a relatively reduced contamination for improved electromigration and for supporting a strongly textured intermediate layer. An intermediate layer comprising aluminum is provided between the titanium underlayer and overlayer. The titanium overlayer has relatively increased contamination as compared to the underlayer to help retain a low sheet resistance.

The reduced contamination of the underlayer is less than about 5 wt.% of a contaminant in an exemplary embodiment. The contaminant can be selected from nitrogen, carbon, and oxygen. Preferably, the underlayer has a thickness of from about 1 nm to about 100 nm or, more preferably, the underlayer has a thickness of from about 10 nm to about 20 nm.

The increased contamination of the overlayer is preferably greater than or equal to about 5 wt % of contaminant; more preferably greater than about 10 wt.% of the contaminant. The overlayer can preferably have a thickness of from about 10 nm to about 100 nm; more preferably, from about 20 nm to about 50 nm.

A TiN layer can be positioned between the underlayer and the intermediate layer in order to reduce the formation of excessive amounts of TiAl3. Such a TiN layer preferably has a thickness up to about 50 nm.

The intermediate layer (such as AlCu) can have a thickness from about 20 nm to about 2,000 nm or, more preferably, a thickness from about 230 nm to about 370 nm. The intermediate layer can be formed from Al alloyed with a solute such as Cu, Si, or Pd.

The present invention also provides a method of forming an interconnect structure. It includes the steps of: (a) degassing a substrate; (b) depositing on the substrate an underlayer comprising titanium, wherein the underlayer has reduced contamination for supporting a strongly textured subsequent layer and for improved electromigration resistance; (c) depositing on the underlayer an intermediate layer comprising aluminum; and (d) depositing on the intermediate layer an overlayer comprising titanium, wherein the overlayer has increased contamination for providing low sheet resistance.

Improving the cleanliness of the underlayer can be accomplished using long throw techniques, collimation, UHV deposition conditions, pasting or Ar cleaning, or high deposition rates. Reducing the cleanliness of the overlayer can be accomplished by using normal throw techniques, UV deposition conditions, lower deposition rates, or a low purity target.

Embodiments of the invention will now be described with reference to the accompanying drawings. It is emphasized that, according to common practice, the various features of the drawings are not to scale. On the contrary, the dimensions of the various features are arbitrarily expanded or reduced for clarity. Included in the drawings are the following figures:
FIG. 1 shows a cross-sectional schematic view of the metallization of an integrated circuit in accordance with an embodiment of the present invention;
FIG. 2 shows a graph of cumulative failure probability against elapsed stress time for non-collimated Ti applied in a dedicated chamber;
FIG. 3 shows a graph of cumulative failure probability against elapsed stress time for collimated Ti applied in a dedicated chamber; and
FIG. 4 shows a graph illustrating the relationship between sheet resistance and the cleanliness of the top Ti layer.

It has been discovered that electromigration is improved when silicon wafers are deposited with a relatively clean Ti underlayer. On the other hand, clean Ti can increase sheet resistance, for example, because of the formation of TiAl3. It has also been discovered that the sheet resistance is improved when wafers are deposited within a relatively dirty Ti overlayer. It has further been discovered that clean Ti contributes significantly to the subsequently deposited Al film being strongly (111) textured. Finally, a correlation has been discovered between reliability performance and the deposition condition of the overlayer and the underlayer.

Accordingly, the reliability performance and functionality of AlCu alloys is significantly controlled by the deposition condition of the Ti/TiN under- and overlayer: (1) wafers deposited with a relatively clean Ti underlayer film show a significantly improved electromigration performance as compared to samples with a contaminated Ti underlayer; and (2) wafers deposited with a relatively dirty Ti overlayer film show significantly improved sheet resistance and time zero resistance in reliability testing as compared to samples with a clean Ti overlayer.

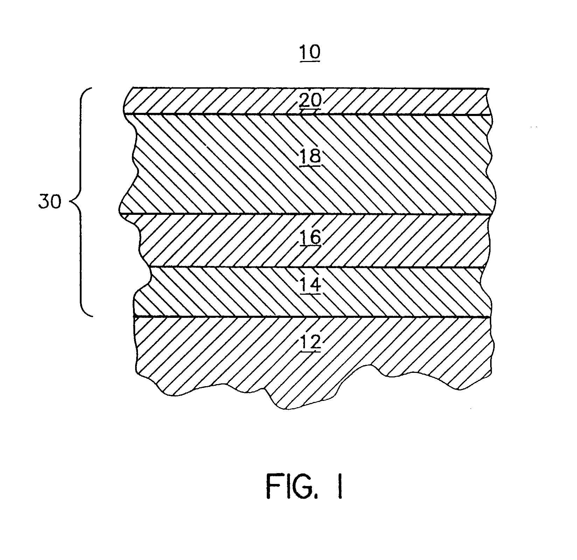

Referring to FIG. 1 for illustration, the numeral "10" generally designates a cross-sectional schematic view of the metallization 30 of an integrated circuit in accordance with an embodiment of the present invention. Integrated circuit 10 includes a body or substrate 12 such as a semiconductor body or a Si single crystal substrate.

Formed on body 12 is an underlayer 14 of titanium (Ti). The thickness of underlayer 14 is preferably in the range of from about 1 nm to about 100 nm and, more preferably, from about 10 nm to about 20 nm. If the underlayer is less than about 1 nm in thickness, it is difficult to ensure that an adequate layer has been deposited. On the other hand, if the underlayer thickness exceeds about 100 nm, then other layers may have to be thinned in order to maintain a predetermined overall thickness of the layered surface and there may be an increased chance of failure of the other layers.

As will be described further below, underlayer 14 should be relatively clean with a controlled degree of contamination. Most preferably, the level of contamination in underlayer 14 should be maintained at or below about 5 wt.%. The contaminates can be selected from nitrogen, carbon, and oxygen as well as any other known contaminants that can be substituted for this purpose. Such contaminants can be used alone or in any combination. As will be described later, underlayer 14 can be deposited with a collimator to make the deposited material more directional, for example, but it need not be applied with a collimator.

Applied to underlayer 14 is a TiN layer 16 that is preferably maintained at a thickness at or below about 50 nm. There should at least be a very thin TiN layer in between the TiN and Al layer (to be described) in order to avoid excessive TiAl3 formation. Although not necessary, this TiN layer 16 can be deposited by collimation as well, if desired.

On top of TiN layer 16 as shown in FIG. 1 is a deposited layer 18 of AlCu. It is preferred for the AlCu layer 18 to be within the range from about 20 nm to about 2,000 nm. More preferably, the thickness of the AlCu layer 18 is maintained within the range from about 230 nm to about 370 nm. The Al in layer 18 can alternatively be alloyed with a wide variety of solutes such as Cu, Si, and Pd, for example, and multiple solutes can also be used (e.g., AlCuSi) of various components.

On AlCu layer 18 is deposited a top overlayer 20 of Ti. An overlayer 20 provides a redundant layer for reliability, as an ARC layer, and as an etch layer stop. This overlayer 20 is relatively dirty as compared to Ti underlayer 14 in order to retain an adequate sheet resistance. The degree of contamination of overlayer 20 is preferably greater than about 10 wt.% of an impurity or contaminant such as nitrogen, oxygen, carbon, or other such contaminants or combinations of such contaminants. The thickness of the overlayer 20 is preferably in the range from about 10 nm to about 100 nm. A more preferred thickness is in the range from about 20 nm to about 50 nm.

Although the exact degree of impurity is not critical to the invention, the impurity should be sufficient to reduce the formation of TiAl3 at the juncture between Ti overlayer 20 and AlCu layer 18. At the same time, the degree of contamination should not be so high as to bring about an excessive contact resistance.

The quality of the underlayer and overlayer in a Complementary Metal-Oxide-Semiconductor (CMOS) wiring stack has been discovered to affect the AlCu texture and sheet resistance as well as the reliability performance. The Ti film quality can be improved (i.e., for the underlayer 14) by using any or all of the following: long throw techniques (with an increased distance between the target material and the deposit surface), collimation, ultra high vacuum (UHV) deposition conditions, pasting or Ar clean to remove surface contamination when Ti/TiN deposition is brought about in the same chamber, and high deposition rates. The Ti film quality can be decreased (i.e., for the Ti overlayer 20) by using normal throw, only UV deposition conditions, no pasting or Ar clean in the combined Ti/TiN chamber (wherein the nitrogen gas is turned off for Ti deposition and turned on for TiN deposition, both performed in the same chamber), lower deposition rates, or by using a low purity target. Various deposition techniques are described in U.S. Patent No. 5,943,601.

The contamination level is controlled by improving the cleanliness of the background vacuum, by limiting the introduction of impurity gases during metal deposition, and by depositing each of the metal layers in a dedicated chamber to limit the cross-contamination from one metal film to another and improve the purity of each metal film. There are several methods for detecting contamination in a metal film. Some common techniques are Auger Electron Spectroscopy, SIMS (Secondary Ion Mass Spectroscopy), and RBS (Rutherford Backscattering).

It has been discovered that clean Ti is highly beneficial as an underlayer in order for the subsequently deposited Al film layer to be strongly (111) textured. This grain orientation in blanket or reactive ion etching (RIE) films correlates with greatly improved electromigration characteristics. In general, the Ti should be relatively clean in the underlayer to have good (002) texture. This (002) texture provides the Al grains with a (111) orientation because the (002) planes in Ti have a very similar interplanar d-spacing to that of the Al (111) close packed planes.

In U.S. Patent No. 5,523,259, Merchant et al. describe a texture controlled Ti layer deposited under conditions which yield a predetermined orientation in a subsequently deposited Al- based layer. Then a plurality of Al-based sublayers are deposited. To begin, a fine-grained first sublayer with essentially a (111) orientation is deposited at a relatively cold temperature on the Ti layer. Next, a second sublayer is deposited on the first sublayer while the temperature is ramped up from the cold temperature to a peak deposition temperature so that, during the ramp-up, a Ti-aluminide layer is formed at the interface between the Ti layer and the first sublayer, and so that the grain size of the Al- based material increases. Finally, a third sublayer is deposited at the peak temperature. According to Merchant et al., fewer grains mean fewer grain boundaries which, in turn, mean fewer defects and, hence, better electromigration characteristics and less stress-induced voiding.

Nevertheless, it has been discovered that the cleanliness of the Ti underlayer is instrumental in the improvement of electromigration resistance. A relatively clean Ti layer can significantly increase the sheet resistance and, at the same time, it can lower electromigration resistance because of increased TiAl3 formation. It has been discovered that a relatively dirty Ti layer should be used to help resist TiAl3 formation and to achieve a decreased metal sheet resistance while still providing good contact resistance and good adhesion.

To achieve good electromigration results, the following sequence can be used:
1. **Degas**
   The substrate is first degassed. This can be accomplished using any conventional method known in the art.
2. **10 nm Collimated (1.5:1.0) Ti**
   Collimated Ti is applied to the degassed substrate. The thickness of this Ti layer d_{Ti} is preferably in the range of about 1 nm ≤ d_{Ti} ≤ 100 nm but, most preferably, in the range of about 10 nm ≤ d_{Ti} ≤ 20 nm. Contamination with contaminants such as nitrogen, carbon, and oxygen is preferably less than about 5 wt.%. It is not necessary for this Ti layer to be deposited with a collimator, but it should be relatively clean. A relatively clean Ti layer can be accomplished using those methods (or similar schemes) mentioned above.
3. 10 **nm Non-Collimated TiN**
   Non-collimated TiN is applied to the Ti underlayer. The thickness of this TiN layer d_{TiN} is preferably in the range of about 0 ≤ d_{TiN} ≤ 50 nm. At least a very thin TiN layer should be positioned between the Ti and Al layer to resist undue TiAl3 formation. This deposition can also be collimated or it can be applied using other known deposition methods.
4. **230 nm Non-Collimated AlCu(about 0.5 wt.% Cu)**
   Non-collimated AlCu is then applied to the TiN layer. The thickness of this AlCu (about 0.5 wt.% Cu) layer d_{AlCu} is preferably in the range of about 20 nm ≤ d_{AlCu} ≤ 2,000 nm. Ideal thicknesses are between about 230 nm and about 370 nm. The Al layer can be alloyed with a wide variety of solutes such as Cu, Si, Pd, and the like, for example, and multiple solutes can also be used (e.g., AlCuSi) of various components.
5. **5 nm Non-Collimated Ti/40 nm**
   **Non-Collimated TiN**
   A Ti overlayer is applied to the AlCu layer. The Ti top layer should be relatively contaminated (m about 10 wt.%), as compared to the underlayer of Ti, to retain a lower sheet resistance. This contamination might include nitrogen, oxygen, carbon, and the like. The exact impurity is not important so long as TiAl3 formation can be reduced. At the other extreme, the contamination level (impurity level) should not be too high or high contact resistance would appear. The thickness of a TiN layer d_{TiN} is preferably in the range of about 10 nm ≤ d_{TiN} ≤ 100 nm. A more preferred thickness is between about 20 nm and 50 nm.

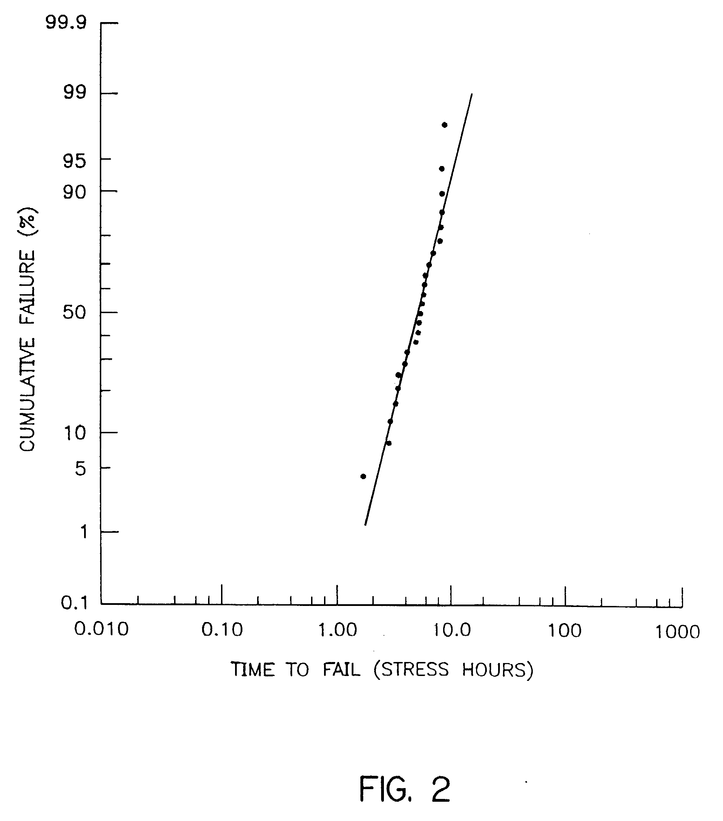

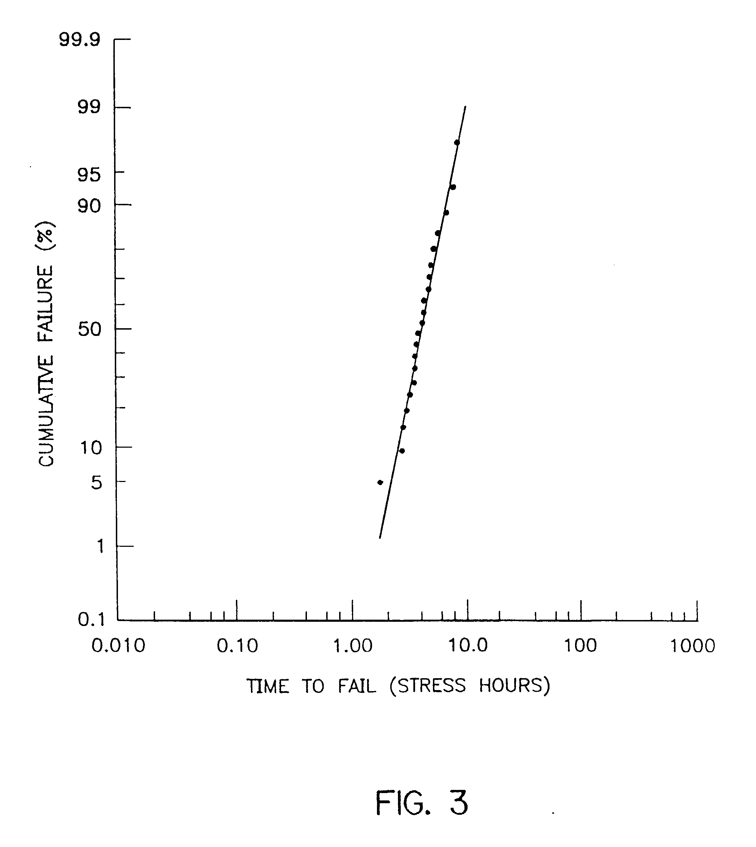

Referring now to FIGS. 2 and 3, reliability test results will now be described. FIGS. 2 and 3 both illustrate, graphically, the time to failure of samples having a Ti layer that is deposited by collimation techniques (FIG. 3) and non-collimation techniques (FIG. 2). The electromigration tests were conducted to compare collimated deposition to non-collimated deposition for clean Ti layers to determine the relative effects of texture and cleanliness on electromigration performance. All of the samples were formed in a dedicated Ti chamber, as opposed to a non-dedicated Ti/TiN chamber, to provide a cleanliness with contaminants comprising less than about 5 wt.% of the Ti layer.

The samples illustrated in FIG. 2 were prepared in a non-collimated chamber. They were then tested for electromigration at 0.81 mA and 250ΓC. The samples illustrated in FIG. 3 were prepared in a collimated chamber. They were also tested for electromigration at 0.81 mA and 250ΓC.

From prior studies (such as those described in U.S. Patent No. 5,943,601), it was expected that the electromigration test results of the collimated samples illustrated in FIG. 3 would have been significantly improved as compared to the non-collimated samples illustrated in FIG. 2 because of the improved texture characteristics that can be achieved using collimation techniques and the perceived relationship between the underlayer's texture and electromigration characteristics.
collimation techniques and the perceived relationship between the underlayer's texture and electromigration characteristics.

Nevertheless, FIGS. 2 and 3 surprisingly illustrate substantially the same reliability test results as between the collimated samples (FIG. 3) and the non- collimated samples (FIG. 2). Instead of confirming that the improved surface texture brought about by collimation techniques is the primary contributor to improved reliability, the results indicate that the cleanliness of the Ti underlayer (brought about by the use of a dedicated Ti chamber in this example) is a significant factor in achieving improved electromigration characteristics and reliability.

The following examples are included to more clearly demonstrate the overall nature of the invention. These examples are exemplary, not restrictive, of the invention.

### EXAMPLE 1

Ti/TiN/AlCu/Ti/TiN (bottom to top) film stacks were formed to determine the correlation between sheet resistance and the cleanliness of the top Ti layer. The structure of each of the film stacks is summarized in the following table:

| Layer Thickness | |
|---|---|
| Top TiN | 40 nm |
| Top Ti | 5 nm |
| AlCu 230 nm | |
| Bottom TiN | 10 nm |
| Bottom Ti | 10 nm |

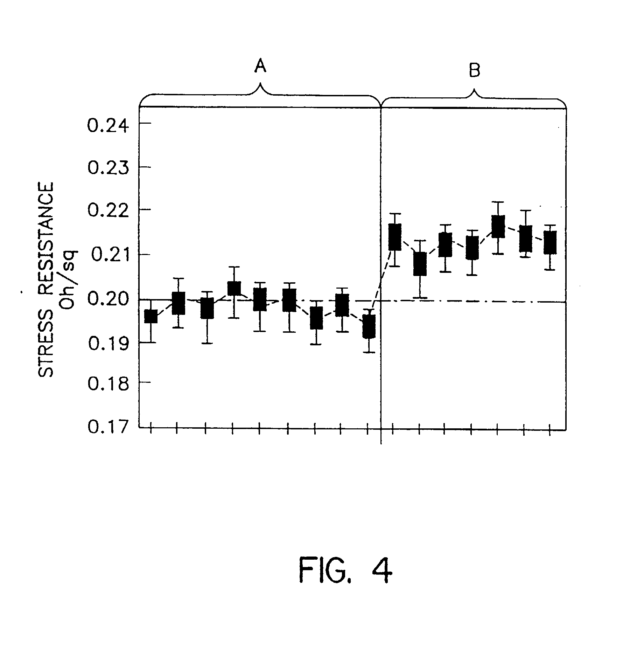

FIG. 4 plots the sheet resistance for the case where the top Ti layer has about 5 wt.% or less of a contaminant (primarily nitrogen), shown on side "B" of FIG. 4, and when it has more than about 5 wt.% of a contaminant (primarily nitrogen), shown on side "A" of FIG. 4. As can be seen by this figure, the sheet resistance is about 5 to 10 wt.% lower when the top Ti layer has increased contamination. This is due at least in part to the prevention of TiAl3 formation between the relatively contaminated top Ti layer and the AlCu conducting layer because of the contamination contained within the Ti layer. Specifically, TiAl3 was formed between the relatively clean Ti top layer and the AlCu layer. On the other hand, no TiAl3 formation was detected between the relatively dirty Ti top layer and the AlCu layer. In this example, depositing Ti and TiN sequentially in the same chamber, leading to cross-contamination of nitrogen into the Ti layer, caused the contamination in the Ti layer. This example illustrates that film stacks with a lower sheet resistance result when the top Ti layer has increased contamination.

### EXAMPLE 2

Ti/TiN/AlCu/Ti/TiN film stacks were formed to determine the correlation between the cleanliness of the bottom Ti layer and electromigration performance. The following table shows electromigration results for two film stacks that were similar except that the bottom Ti has about 5 wt.% or less of a contaminant (deposited in a dedicated chamber) in one case and has more than about 5 wt.% of a contaminant (deposited in a shared chamber) in the other case.

| | | | | |
|---|---|---|---|---|
| Cleanliness of Bottom Ti Layer to Mean Time to Failure (hours) Density (mA/um2) | | | | Mean Time to Failure (hours) Deviation Maximum Potential Applied Current |
| Relatively clean | 7.9 | 0.26 | 2.48 | |
| Relatively dirty | 3.2 | 0.34 | 1.09 | |

The sample with the relatively clean Ti had a significantly improved electromigration mean time to failure, deviation to mean time to failure, and maximum potential current density as compared to the sample with the relatively dirty Ti. This is characteristic of better electromigration performance for the sample with a Ti bottom layer having reduced contamination.

## Claims

1. An interconnect for an integrated circuit comprising:
an underlayer comprising titanium having reduced contamination for improved electromigration and for supporting another layer;
an intermediate layer comprising aluminum; and
an overlayer comprising titanium having increased contamination relative to said underlayer to provide a reduced sheet resistance.

2. The interconnect defined in claim 1, wherein said reduced contamination of said underlayer consists of about 5 wt.% or less of a contaminant.

3. The interconnect defined in claim 2, wherein said contaminant is selected from the group consisting of nitrogen, carbon, and oxygen.

4. The interconnect defined in claim 1, wherein said underlayer has a thickness of from about 1 nm to about 100 nm.

5. The interconnect defined in claim 1, wherein said increased contamination of said overlayer consists of more than about 5 wt.% of a contaminant.

6. The interconnect defined in claim 1, wherein said overlayer has a thickness of from about 10 nm to about 100 nm.

7. The interconnect defined in claim 1, further comprising a TiN layer positioned between said underlayer and said intermediate layer in order to resist the undue formation of TiAl3.

8. The interconnect defined in claim 7, wherein said TiN layer has a thickness of up to about 50 nm.

9. The interconnect defined in claim 1, wherein said intermediate layer comprises AlCu.

10. The interconnect defined in claim 1, wherein said intermediate layer has a thickness from about 20 nm to about 2,000 nm.

11. The interconnect defined in claim 1, wherein said intermediate layer is formed from Al alloyed with a solute.

12. The interconnect defined in claim 15, wherein said solute is selected from the group consisting of Cu, Si, and Pd.

13. A method of forming an interconnect for an integrated circuit comprising the steps of:
(a) degassing a substrate;
(b) depositing on said substrate an underlayer comprising titanium, wherein said underlayer has reduced contamination for improved electromigration resistance;
(c) depositing on said underlayer an intermediate layer comprising aluminum; and
(d) depositing on said intermediate layer an overlayer comprising titanium, wherein said overlayer has increased contamination relative to said underlayer for providing reduced sheet resistance.

14. The method defined in claim 13, wherein said underlayer depositing step comprises the use of a technique selected from the group consisting of long throw, collimation, UHV deposition, pasting or Ar cleaning, and high deposition rates.

15. The method defined in claim 13, wherein said overlayer depositing step comprises the use of a technique selected from the group consisting of normal throw, UV deposition, low deposition rates, and low purity target.
